# DEMANDE DE BREVET EUROPEEN

(11) **EP 0 800 185 A1**
(43) Date de publication de la demande: **08.10.1997**
(21) Numéro de dépôt: 97200946.8
(22) Date de dépôt: 01.04.1997
(51) Int. Cl.: H01F 21/04

(54) **Appareil comprenant au moins un dispositif d'inductance réglable**

(30) Priorité: 03.04.1996 FR 9604193
(71) Demandeur: Philips Electronics N.V., 5621 BA Eindhoven (NL)
(72) Inventeur: Ducoffe, Hervé, 156, Boulevard Haussmann 75008 Paris (FR)
(74) Mandataire: Caron, Jean

(57) **Abrégé**

Dispositif d'inductance réglable, réalisé sous la forme d'un bobinage à air comprenent deux parties de bobinage (1A,1B) placées dans le prolongement l'une de l'autre et faites de spires de fil conducteur, ce bobinage étant destiné à être réglé par modification de l'écartement entre certaines de ses spires.

Le dispositif comporte un bobinage en deux parties (1A,1B) placées dans le prolongement l'une de l'autre, fixé à une plaque support (2) avec l'axe principal (8) du bobinage parallèle à cette plaque, et des lames (4,5,6) attachées de façon élastique à la plaque, dont l'une (5) passe entre les deux parties du bobinage.

Applications: radio et télévision

## Description

La présente invention concerne un appareil électronique, avec un circuit de sélection de fréquence comprenant au moins un dispositif d'inductance réglable, réalisé sous la forme d'un bobinage à air comprenant deux parties de bobinage placées dans le prolongement l'une de l'autre et faites de spires de fil conducteur, ce bobinage étant destiné à être réglé par modification de l'écartement entre certaines de ses spires.

Un tel appareil électronique est, par exemple mais pas exclusivement, un récepteur de radio ou de télévision.

Un dispositif d'inductance réglable est connu du brevet US-2,722,662. Selon ce document, une bobine est séparée en deux parties indéformables reliées par une partie élastique, et la valeur de l'inductance est réglable par déplacement d'une des parties indéformables par rapport à l'autre. Les moyens pour réaliser un tel déplacement ne sont pas indiqués.

Un objet de l'invention est de fournir un bobinage dont le réglage, par modification de l'écartement entre spires, soit facilement mécanisable.

A cet effet, le bobinage étant fixé à une plaque support avec l'axe principal du bobinage sensiblement parallèle à cette plaque, le dispositif comprend, pour modifier l'écartement entre les spires, au moins un levier mobile attaché à la plaque et qui passe entre les deux parties du bobinage.

L'invention est donc basée sur l'idée de pourvoir le bobinage d'un accessoire qui lui est attaché de façon permanente, et peut être saisi par une machine.

Avantageusement, le dispositif comporte au moins un autre levier attaché à la plaque, et placé à une extrémité du bobinage.

Dans une forme de réalisation particulière, un levier est constitué par une lame élastique ou attachée de façon élastique.

Avantageusement, le levier, de son côté le plus éloigné de la plaque, comporte un orifice, ouvert d'un côté.

Cela permet de passer dans cet orifice une barre de commande avec laquelle plusieurs lames sont mues en même temps.

Ces aspects de l'invention ainsi que d'autres aspects plus détaillés apparaîtront plus clairement grâce à la description suivante d'un mode de réalisation constituant un exemple non limitatif.

La figure 1 représente schématiquement un appareil électronique, ici un récepteur de radio ou de télévision, avec un circuit de sélection de fréquence comprenant au moins une inductance.
La figure 2 représente, vu de côté, un bobinage selon l'invention.
La figure 3 représente le même bobinage, vu en coupe selon AA de la figure 1.

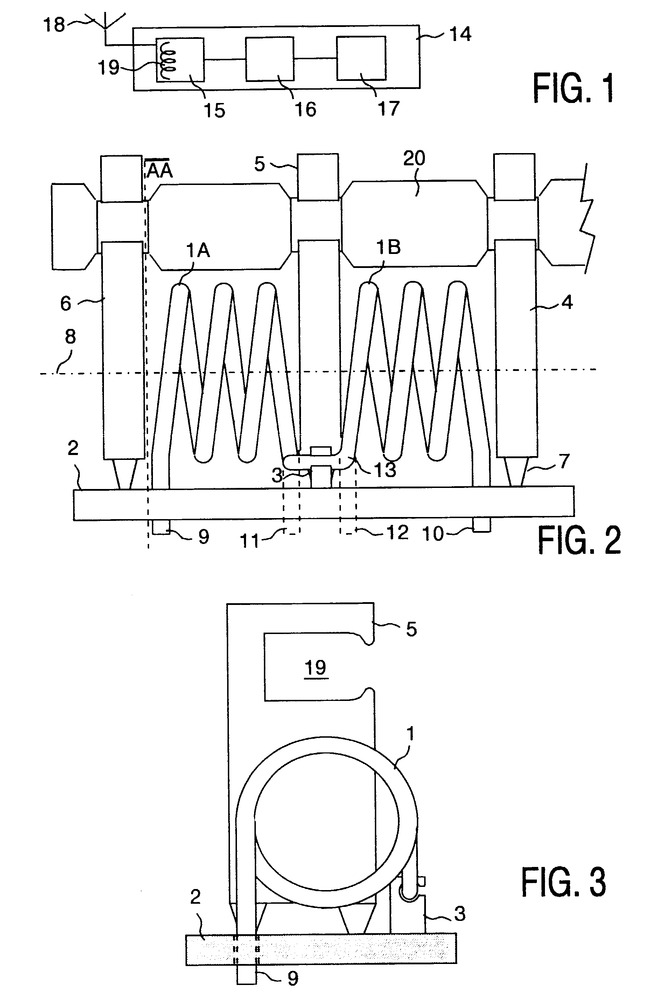

L'appareil 14 représenté sur la figure 1 comporte des éléments, tous connus en soi :
- un syntoniseur 15 qui, à partir d'un antenne 18, sélectionne une gamme de fréquences d'entrée au moyen d'un circuit de sélection de fréquence et comprend au moins une inductance réglable 19, et réalise un changement de fréquence, et délivre un signal à fréquence intermédiaire,
- un amplificateur-démodulateur 16, qui amplifie et démodule le signal à fréquence intermédiaire, et délivre des signaux en bande de base,
- un ensemble de circuits 17, comprenant des moyens, vidéo et/ou audio, pour le traitement des signaux en bande de base.

Le bobinage représenté par la figure 2, qui correspond à l'inductance réglable 19 de la figure 1, est réalisé sous la forme d'un bobinage à air comprenant deux parties de bobinage 1A et 1B, placées dans le prolongement l'une de l'autre et faites de spires de fil conducteur. Ce bobinage est destiné à être réglé par modification de l'écartement entre la partie 1A et la partie 1B. Il est attaché à une plaque 2 à ses deux extrémités 9 et 10. L'axe principal 8 du bobinage est parallèle à la plaque 2. La plaque 2 est, par exemple, mais pas nécessairement, une plaque de circuit imprimé. Il peut s'agir d'une plaque attachée à un circuit imprimé plus grand qu'elle, par exemple perpendiculairement à ce dernier. Pour modifier l'écartement entre les spires, la plaque est munie d'une première lame 5, qui est attachée de façon élastique à la plaque 2 et qui passe entre les deux parties du bobinage, et de deux autres lames 4 et 6, également attachées de façon élastique à la plaque, et qui sont placées à chaque extrémité du bobinage. Les lames sont attachées de façon élastique au moyen de parties flexibles, dont l'une, qui supporte la lame 4, est référencée 7. Ces parties flexibles peuvent prendre toute forme connue de l'homme du métier, par exemple mais pas exclusivement : une pièce intermédiaire en métal mince ou en caoutchouc, ou une partie amincie de la lame 4. Au lieu d'être rigides et attachées par un lien flexible, les lames pourraient aussi bien être élastiques par elles mêmes.

Les deux parties de bobinage sont constituées par un seul fil, qui est maintenu par un support fixe 3 entre les deux parties 1A et 1B. Ce support 3 comporte un trou ouvert, dans lequel le fil peut être entré par clipsage. Les deux parties 1A, 1B pourraient tout aussi bien être faites de deux fils distincts, ayant chacun ses deux extrémités attachées à la plaque, comme cela est suggéré par des extrémités 11 et 12 figurées en pointillé.

Sur la figure 3, le bobinage vu en bout, comporte des spires circulaires dont une est visible en 1, avec des extrémités, dont une est visible en 9, attachées à la plaque 2. L'extrémité d'une lame, la plus éloignée de la plaque 2, comporte un orifice 19 ouvert d'un côté. Cette ouverture permet d'insérer une barre de commande 20, représentée schématiquement sur la figure 2 seulement, qui peut mouvoir les trois lames en même temps.

Le dispositif fonctionne de la façon suivante : si la lame 5 est poussée, par exemple, vers la droite, elle pousse la partie de bobinage 1B, qui se déforme essentiellement par flexion au niveau de l'extrémité 13, fixée au support 3, et l'ensemble des trois spires constituant la partie 1B se déplace pratiquement en bloc vers la droite. Du fait que la partie 1B s'éloigne de la partie 1A, l'inductance totale diminue. Si on dépasse le point de réglage optimal, il suffit de pousser la lame 4 vers la gauche, et alors la partie de bobinage 1B se déforme essentiellement par flexion au niveau de son extrémité 10, et l'ensemble des trois spires constituant la partie 1B se déplace pratiquement en bloc vers la gauche.

Lorsque les trois lames sont solidarisées par une barre de commande, un mécanisme plus ou moins complexe pour choisir la lame à déplacer n'est pas nécessaire ; dans ce cas, si par exemple l'ensemble est d'abord poussé vers la droite, la partie 1B est écartée de la partie 1A par la lame 5 et l'inductance diminue ; lors d'une éventuelle poussée subséquente de l'ensemble vers la gauche, la lame 4 ramènerait la partie 1B vers la partie 1A, et le réglage reviendrait vers sa valeur de départ. Le même effet pourrait être obtenu en poussant d'abord la barre vers la gauche, c'est-à-dire en agissant sur la partie 1A. Tout ceci peut donc être facilement piloté par un mécanisme simple, commandé par un ordinateur qui reçoit des données indiquant l'effet produit, de la part d'instruments de mesure électrique.

L'espace dans lequel la lame 5 passe entre deux spires est ici plus grand que les autres espaces entre spires. Ceci n'est pourtant pas obligé et on pourrait aussi imaginer une ou plusieurs lames suffisamment minces pour passer entre n'importe lesquelles des spires, à condition toutefois que le fil soit maintenu à ce niveau par un support approprié, dans le genre du support 3.

## Revendications

1. Appareil électronique, avec un circuit de sélection de fréquence comprenant au moins un dispositif d'inductance réglable, réalisé sous la forme d'un bobinage à air comprenant deux parties de bobinage placées dans le prolongement l'une de l'autre et faites de spires de fil conducteur, ce bobinage étant destiné à être réglé par modification de l'écartement entre certaines de ses spires, **caractérisé en ce que,** le bobinage étant fixé à une plaque support avec l'axe principal du bobinage sensiblement parallèle à cette plaque, le dispositif comprend, pour modifier l'écartement entre les spires, au moins un levier mobile attaché à la plaque et qui passe entre les deux parties du bobinage.

2. Appareil électronique selon la revendication 1, **caractérisé en ce que** le dispositif comporte au moins un autre levier attaché à la plaque, et placé à une extrémité du bobinage.

3. Appareil électronique selon l'une des revendications 1 ou 2, **caractérisé en ce que** un levier est constitué par une lame élastique ou attachée de façon élastique.

4. Appareil électronique selon l'une quelconque des revendications 1 à 3, **caractérisé en ce que** le levier, de son côté le plus éloigné de la plaque, comporte un orifice, ouvert d'un côté.

5. Appareil électronique selon l'une quelconque des revendications 1 à 4, **caractérisé en ce que** les deux parties de son bobinage sont constituées par un seul fil, qui est maintenu entre les deux parties par un support fixe.

6. Appareil électronique selon l'une quelconque des revendications 1 à 4, **caractérisé en ce que** les deux parties de son bobinage sont distinctes et ont chacune leurs deux extrémités attachées à la plaque.
